# EUROPEAN PATENT APPLICATION

(11) **EP 1 845 061 A2**
(43) Date of publication of application: **17.10.2007**
(21) Application number: 06254625.4
(22) Date of filing: 05.09.2006
(51) Int. Cl.: B81B 7/00

(54) **Method for making via holes filled with conductive material in MEMS devices and device with such vias**

(30) Priority: 14.04.2006 KR 20060034182
(71) Applicant: Samsung Electronics Co., Ltd., Suwon-si, Gyeonggi-Do (KR)
(72) Inventor: Ko, Young-chul, Giheung-gu Yongin-si Gyeonggi-do (KR); Choi, Won-kyoung Samsung Raemian Apt., Yeongtong-gu Suwon-si Gyeonggi-do (KR); Chung, Seok-whan, Yeontong-gu Suwon-si Gyeonggi-do (KR)
(74) Representative: Greene, Simon Kenneth

(57) **Abstract**

Provided is a MEMS device that uses a SOI wafer, and a method of manufacturing the same. The MEMS device includes a SOI wafer consisted of a first silicon layer, a second silicon layer, and an insulating layer formed between the first and second silicon layers, and a protective substrate that is combined to the first silicon layer, wherein grounding via holes are formed through the first silicon layer, the insulating layer and the protective substrate, and filled with a conductive material, and ventilation holes to be connected to the grounding via holes are formed in the second silicon layer.

## Description

The present invention relates to a micro-electro mechanical system (MEMS) device that uses a silicon on insulator wafer, and more particularly, to a MEMS device that uses a silicon on insulator wafer having a structure that grounds a handle wafer and via holes, and a method of manufacturing the same.

The manufacture of a high speed and low power consumption device using conventional semiconductor substrates, for example, a silicon substrate, encounters a critical limit. Therefore, to overcome this limit, a silicon-on-insulator (SOI) that enables the formation of a completely-depleted device has been developed.

In general, a SOI substrate consists of a first silicon layer which is formed of silicon Si and is a lower handle wafer used as a substrate, a second silicon layer which is formed of silicon Si and is an upper device wafer where devices are formed, and a sacrifice insulating layer which is interposed between the first and second silicon layers, is formed of silicon oxide SiO₂, and has a cavity for moving a device.

The SOI substrate has low parasitic capacitance since an insulating layer is buried between the handle wafer and the device wafer, thereby increasing device performance. Accordingly, the SOI substrate can increase operation speed at the same voltage, and can reduce power voltage at the same speed.

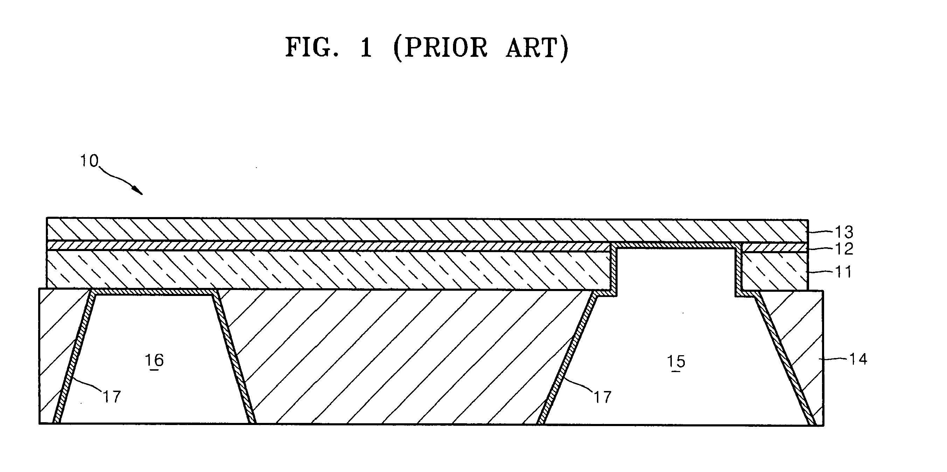

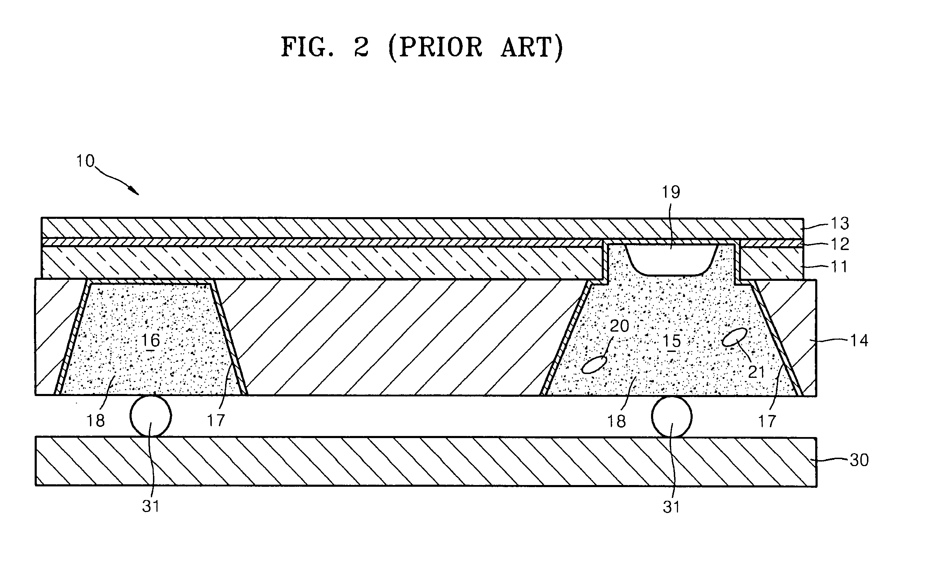

FIGS. 1 and 2 are cross-sectional views of structures of conventional MEMS devices 10 that use a solder ball packaging bonding method.

Referring to FIG. 1, the MEMS device 10 that uses a solder ball packaging bonding method includes a first silicon layer 11 which is a handle wafer, an insulating layer 12 formed of silicon oxide, a second silicon layer 13 which is a device wafer, and a protective substrate 14 which is a cover glass.

The protective substrate 14 includes via holes 15 and 16 for transmitting signals or grounding. The via hole 15 connects the protective substrate 14, the first silicon layer 11, and the insulating layer 12, and the via hole 16 connects the protective substrate 14 and the first silicon layer 11. A conductive layer 17 is deposited in each inner surface of the via hole 15 and 16 using a conductive material.

The via holes 15 and 16 are filled with a conductive material 18, and the via holes 15 and 16 in the protective substrate 14 are bonded to a printed circuit substrate 30 using solder balls 31.

However, as depicted in FIG. 2, voids 19, 20, and 21 are formed in the via hole 15, but voids are not formed in the via hole 16. The voids 19, 20, and 21, particularly, the void 19, cause electrical disconnections, thereby reducing bonding characteristics.

The voids 19, 20, and 21 are caused by air remaining in the via hole 15 instead of leaving the via hole 15 when the via hole 15 is filled with the conductive material 18 and when the first and second silicon layers 11 and 13 are bonded to the insulating layer 12 and air generated due to vaporization of the conductive material.

Therefore, there is a need to develop a method that can avoid the generation of the voids 19, 20, and 21 in the via hole 15 when the via hole 15 is filled with the conductive material 18.

The present invention provides a MEMS device that uses a SOI wafer to prevent a via hole from generating voids when the via hole is filled with a conductive material to ground a device wafer and a method of manufacturing the same.

According to an aspect of the present invention, there is provided a MEMS device that uses a SOI wafer, the SOI wafer comprised of a first silicon layer; a second silicon layer; and an insulating layer formed between the first and second silicon layers, comprising a protective substrate that is combined to the first silicon layer; grounding via holes that are formed through the first silicon layer, the insulating layer and the protective substrate, and are filled with a conductive material, and ventilation holes to be connected to the grounding via holes in the second silicon layer.

According to another aspect of the present invention, there is provided a method of manufacturing a MEMS device that uses a SOI wafer, the method comprising: (a) preparing a first silicon layer, a second silicon layer, and an SOI wafer including an insulating layer between the first and second silicon layers; (b) forming grounding via holes connecting from a protective substrate to the insulating layer by bonding the protective layer to the SOI wafer; (c) forming ventilation holes to be connected to the grounding via holes through the second silicon layer; (d) removing the insulating layer exposed through the grounding via holes; and (e) grounding the second silicon layer by filling a conductive material in the grounding via holes.

The above and other features and advantages of the present invention will become more apparent by describing in detail exemplary embodiments thereof with reference to the attached drawings in which:
FIGS. 1 and 2 are cross-sectional views of structures of conventional MEMS devices that use a solder ball packaging bonding method;
FIG. 3 is a cross-sectional view of a structure of a MEMS device that uses a SOI wafer according to an embodiment of the present invention;
FIG. 4 is a cross-sectional view for explaining an operation of the structure of a MEMS device that uses a SOI wafer of FIG. 3; and
FIGS. 5A through 5G are cross-sectional views illustrating a method of manufacturing a MEMS device that uses a SOI wafer according to an embodiment of the present invention.

The present invention will now be described more fully with reference to the accompanying drawings in which exemplary embodiments of the invention are shown.

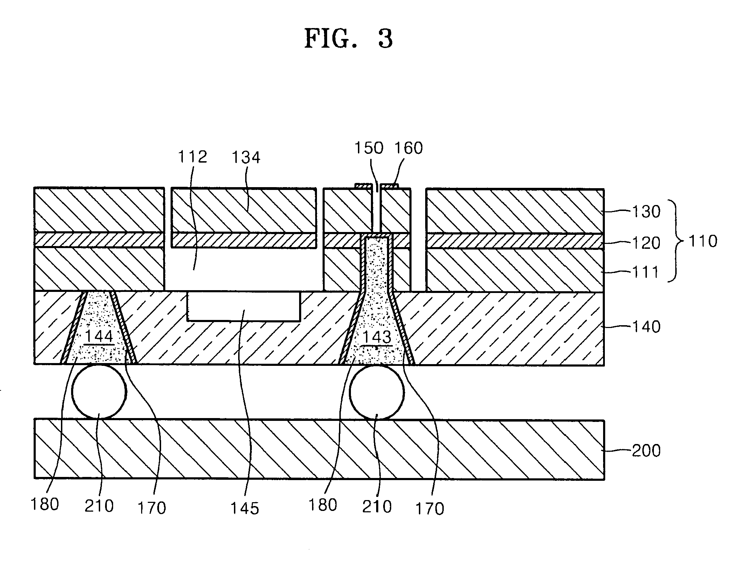

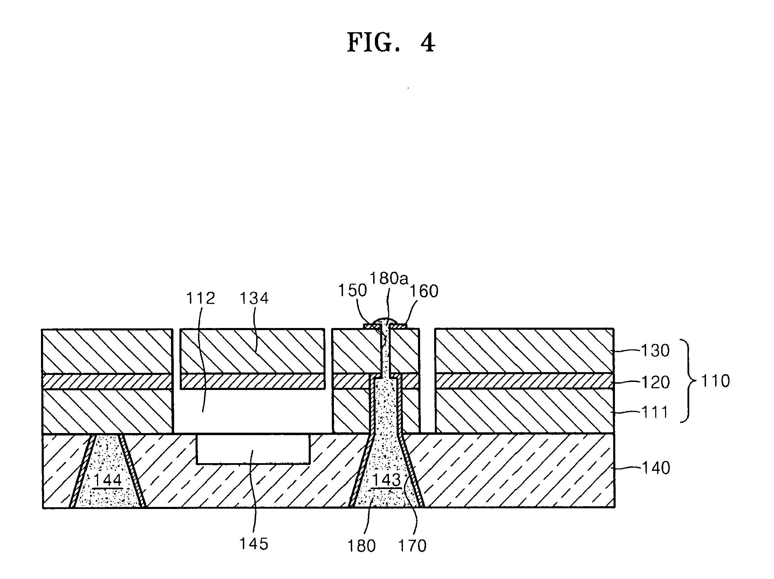

FIG. 3 is a cross-sectional view of a structure of a MEMS device that uses a SOI wafer according to an embodiment of the present invention, and FIG. 4 is a cross-sectional view for explaining an operation of the structure of a MEMS device that uses a SOI wafer of FIG. 3.

Referring to FIGS. 3 and 4, a MEMS device 100 according to an embodiment of the present invention includes: a SOI wafer 110 consisted of a first silicon layer 111, a second silicon layer 130, and an insulating layer 120 interposed therebetween and formed of silicon oxide SiO₂; a protective substrate 140 formed to bond on a lower surface of the first silicon layer 111; a grounding via hole 143 which is formed through the protective substrate 140, the first silicon layer 111, and the insulating layer 120 and filled with a conductive material 180; a ventilation hole 150 formed in the second silicon layer 130 so as to be connected to the grounding via hole 143; and a stopping unit 160 on an upper side of the ventilation hole 150.

The first silicon layer 111 serves as a lower handle wafer, and the second silicon layer 130 serves as an upper device wafer on which a device 134 is formed. A cavity 112 for moving the device 134 is formed in the first silicon layer 111. A cavity 145 corresponding to the cavity 112 for moving the device 134 can be formed in the protective substrate 140.

The grounding via hole 143 is formed through the protective substrate 140, the first silicon layer 111, and the insulating layer 120, and a conductive layer 170 is deposited on an inner surface of the grounding via hole 143 using a metal. The grounding via hole 143 is filled with a conductive material 180 to be electrically connected to the second silicon layer 130. A signal via hole 144 to be electrically connected to the first silicon layer 111 is formed in the protective substrate 140. The signal via hole 144 has also the conductive layer 170 formed of a metal on an inner surface thereof and is filled with the conductive material 180.

The ventilation hole 150 to be connected to the grounding via hole 143 is formed in a location of the second silicon layer 130 corresponding to the grounding via hole 143. The ventilation hole 150 is formed to exhaust air filled in the grounding via hole 143 or air generated by the volatilization of the conductive material 180 when the grounding via hole 143 is filled with the conductive material 180.

The stopping unit 160, as depicted in FIG. 4, is formed to surround an upper part of the ventilation hole 150 on the second silicon layer 130, and stops further flowing out the conductive material 180 along the upper part of the second layer 130 when a portion of the conductive material 180a overflows on the second silicon layer 130 through the ventilation hole 150.

The grounding via hole 143 and the signal via hole 144 are electrically connected to the printed circuit substrate using a conductive adhesive 210.

A method of manufacturing a MEMS device that uses a SOI wafer according to the present invention will now be described with reference to drawings. Same reference numerals are used to indicate elements having the same function with those depicted in FIGS. 3 and 4. Hereinafter, the removal of a portion of a layer to form a predetermined cavity in the layer is performed using a conventional etching method, and thus, the detailed description thereof will not be repeated.

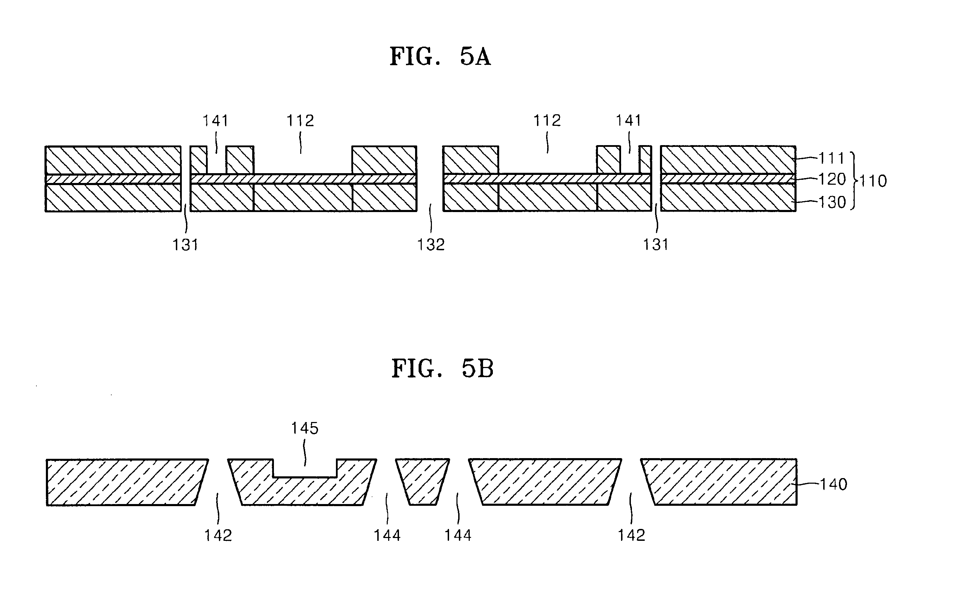

FIGS. 5A through 5G are cross-sectional views illustrating a method of manufacturing a MEMS device that uses a SOI wafer according to an embodiment of the present invention.

Referring to FIG. 5A, a SOI wafer 110 consisted of a first silicon layer 111, an insulating layer 120, and referring to FIG. 5B, a second silicon layer 130 is prepared. A cavity 112 for moving a device 134 is formed in the first silicon layer 111. First grounding via holes 141 are formed by etching the first silicon layer 111 until the insulating layer 120 is exposed. Reference numerals 131 and 132 indicate holes having predetermined sizes formed by etching portions of the SOI wafer 110 to manufacture devices.

Referring to FIG. 5B, a protective substrate 140 is prepared. A cavity 145 for moving the device 134 is formed in the protective substrate 140 corresponding to the cavity 112 in the first silicon layer 111. A plurality of second grounding via holes 142 and a plurality of signal via holes 144 are formed through the protective substrate 140. The second grounding via holes 142 may be formed on locations of the protective substrate 140 corresponding to the first grounding via holes 141.

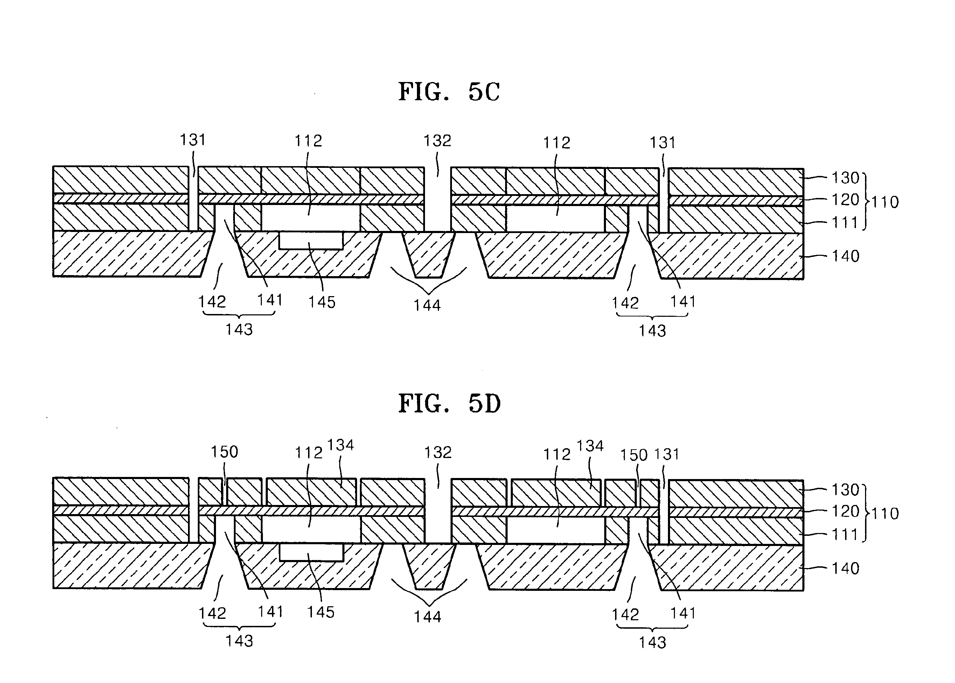

Referring to FIG. 5C, the protective substrate 140 is combined to the SOI wafer 110. More specifically, the protective substrate 140 is bonded on the first silicon layer 111 of the SOI wafer 110.

When the protective substrate 140 is combined to the first silicon layer 111, a grounding via hole 143 is formed by connecting the first grounding via holes 141 formed through the first silicon layer 111 and the second grounding via holes 142 formed through the protective substrate 140. The signal via holes 144 extend to the first silicon layer 111 from an upper part of the protective substrate 140.

The combining of the protective substrate 140 to the SOI wafer 110 can be performed using a conventional method, and thus, the detailed description thereof will be omitted.

Referring to FIG. 5D, a ventilation hole 150 corresponding to the grounding via hole 143 is formed by etching the second silicon layer 130 until the insulating layer 120 is exposed. The ventilation hole 150 may have a diameter smaller than the diameter of the grounding via hole 143. The ventilation hole 150 is a path for leaving air. Therefore, the ventilation hole 150 does not need to have a larger diameter than the grounding via hole 143.

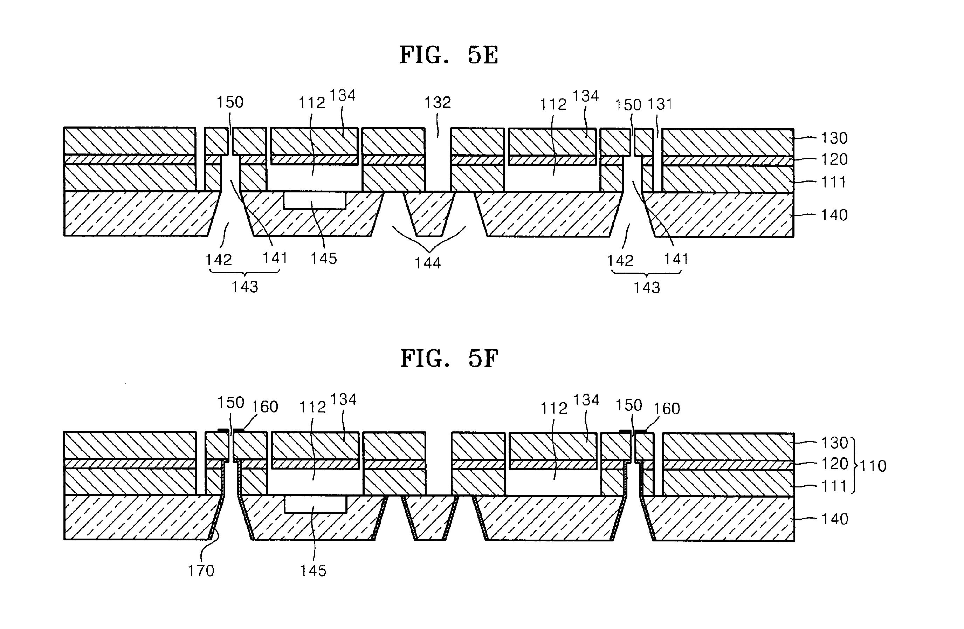

Referring to FIG. 5E, a portion of the insulating layer 120 exposed in the grounding via hole 143 is removed. Accordingly, the grounding via hole 143 is connected to the ventilation hole 150.

Referring to FIG. 5F, a stopper unit 160 that surrounds the ventilation hole 150 is formed on an upper surface of the second silicon layer 130. The stopper unit 160 may be formed of a metal.

A conductive layer 170 is deposited respectively on inner surfaces of the grounding via holes 143 and the signal via holes 144 using a metal. When the conductive layer 170 is deposited on the inner surfaces of the grounding via holes 143 and the signal via holes 144, the protective substrate 140 and the second silicon layer 130 or the first silicon layer 111 can be electrically connected.

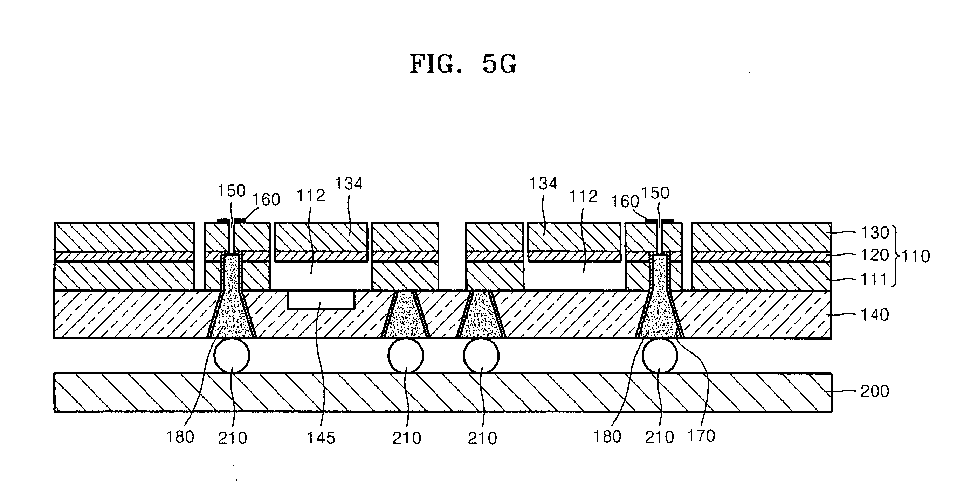

Referring to FIG. 5G, the grounding via holes 143 and the signal via holes 144 are filled with a conductive material 180. At this time, air generated by the volatilization of the conductive material 180 when the conductive is filled in the grounding via holes 143 and the signal via holes 144 is exhausted through the ventilation holes 150. Therefore, voids are not formed in the conductive material 180, thereby increasing connection yield.

Afterward, the grounding via holes 143 and the signal via holes 144 are electrically connected to a printed circuit substrate 200 using a conductive adhesive (solder paste) 210.

As described above, a MEMS device that uses a SOI wafer according to the present invention can increase the electrical connection yield by exhausting air generated by the volatilization of a conductive material through a ventilation hole formed on an opposite side of a grounding via hole when the conductive material is filled in the grounding via hole.

While the present invention has been particularly shown and described with reference to exemplary embodiments thereof, it will be understood by those of ordinary skill in the art that various changes in form and details may be made therein without departing from the scope of the present invention as defined by the following claims.

## Claims

1. A micro-electro mechanical system, MEMS, device that uses a silicon-on-insulator, SOI, wafer (110) comprising a first silicon layer (111); a second silicon layer (130); and an insulating layer (120) formed between the first (111) and second (130) silicon layers, wherein the MEMS device comprises:
a protective substrate (140) that is bonded to the first silicon layer (111);
a grounding via hole (143) that is formed through the first silicon layer (111), the insulating layer (120) and the protective substrate (140), and is filled with a conductive material (180); and
a ventilation hole (150) connected to the grounding via hole (143) in the second silicon layer (130).

2. The MEMS device of claim 1, wherein the ventilation hole (150) has a smaller diameter than the diameter of the grounding via holes (143).

3. The MEMS device of claim 1, further comprising a stopper unit (160) that surrounds an upper part of the ventilation hole on an upper part of the second silicon layer (130).

4. The MEMS device of claim 3, wherein the stopper unit (160) is formed of a metal.

5. A method of manufacturing a MEMS device that uses a SOI wafer, the method comprising:
(a) preparing a first silicon layer (111), a second silicon layer (130), and an SOI wafer (110) including an insulating layer (120) between the first (111) and second (130) silicon layers;
(b) forming a grounding via hole (143) connecting from a protective substrate (140) to the insulating layer (120) by bonding the protective substrate (140) to the SOI wafer (110);
(c) forming a ventilation hole (150) that is connected to the grounding via hole (143) through the second silicon layer (130);
(d) removing the insulating layer (120) exposed through the grounding via hole (143); and
(e) grounding the second silicon layer (130) by filling a conductive material (180) in the grounding via hole (143).

6. The method of claim 5, wherein the forming of a protective substrate (140) on a lower part of the first silicon layer (111) and grounding via hole (143) through the first silicon layer (111) and the protective substrate (140) comprises:
forming a first grounding via hole (141) that penetrates from an upper surface of the first silicon layer (111) to the insulating layer (120);
forming a second grounding via hole (142) in the protective substrate (140); and
forming the grounding via hole (143) by combining the first grounding via hole (141) and second grounding via hole (142) by bonding the protective substrate (140) to the SOI wafer (110).

7. The method of claim 5, wherein the ventilation hole (150) has a smaller diameter than the diameter of the grounding via hole (143).

8. The method of claim 5, further comprising forming a stopper unit (160) to surround the ventilation hole (150) on an upper surface of the second silicon layer (130) after the step (d).

9. The method of claim 8, wherein the stopper unit (160) is formed of a metal.

10. The method of any of claims 5 to 9, wherein the step (a) comprises:
providing the first silicon layer (111);
forming an insulating layer (120) formed of a silicon oxide on the first silicon layer (111); and
forming a second silicon layer (130) on the insulating layer (120).
